# EUROPÄISCHE PATENTSCHRIFT

(11) **EP 0 783 046 B1**
(45) Veröffentlichungstag und Bekanntmachung des Hinweises auf die Patenterteilung: **28.07.1999**
(21) Anmeldenummer: 96119963.5
(22) Anmeldetag: 12.12.1996
(51) Int. Cl.: C30B 15/00, C30B 29/06

(54) **Verfahren und Vorrichtung zum Ziehen eines Einkristalls**
Method and apparatus of drawing a single crystal
Méthode et dispositif pour le tirage d'un monocristal

(30) Priorität: 15.12.1995 DE 19546987
(43) Veröffentlichungstag der Anmeldung: 09.07.1997
(73) Patentinhaber: Wacker Siltronic Gesellschaft für Halbleitermaterialien Aktiengesellschaft, 84489 Burghausen (DE)
(72) Erfinder: Dornberger, Erich, 84489 Burghausen (DE); von Ammon, Wilfried, Dr., 84489 Burghausen (DE)
(74) Vertreter: Rimböck, Karl-Heinz, Dr.

(56) Entgegenhaltungen:
- FR-A- 1 420 234

## Beschreibung

Gegenstand der Erfindung ist ein Verfahren zum Ziehen eines Silicium-Einkristalls aus einer Schmelze, umfassend das Ziehen je eines konusförmigen Abschnitts am Anfang und am Ende des Einkristalls und das Ziehen eines zylindrischen Abschnitts zwischen den konusförmigen Abschnitten. Darüber hinaus betrifft die Erfindung auch eine Vorrichtung zur Durchführung des Verfahrens.

Die Erfindung stellt eine Verbesserung der unter dem Begriff "Czochralski-Verfahren" bekannten Methode zur Herstellung von Einkristallen dar. Gemäß dieser Methode wird ein Impfkristall, der zuvor in eine Schmelze getaucht worden ist, mit einer bestimmten Geschwindigkeit von der Schmelzenoberfläche fortgezogen, wobei auf seiner Unterseite ein stabförmiger Einkristall aufwächst. Nach dem Ziehen eines sogenannten Dünnhalses wird der Durchmesser des wachsenden Einkristalls zunächst vergrößert, so daß ein konusförmiger Abschnitt, der sogenannte Anfangskonus, entsteht. Nach dem Anfangskonus wird der Durchmesser des wachsenden Einkristalls konstant gehalten und ein zylindrischer Abschnitt gezogen. Zum Schluß wird der Durchmesser des Einkristalls wieder verringert. Der dadurch entstehende Abschnitt am Ende des Einkristalls wird Endkonus genannt. Änderungen des Einkristall-Durchmessers gehen maßgeblich auf Änderungen der Ziehgeschwindigkeit und auf Änderungen der Temperaturverhältnisse in der Schmelze, insbesondere im Bereich der Kristallisationsgrenze, zurück.

Bisher war es üblich, den Anfangskonus, einen 30 bis 50 mm langen Teil des an den Anfangskonus angrenzenden zylindrischen Abschnitts und den Endkonus vom Einkristall abzutrennen und nur den zylindrischen Hauptteil des Einkristalls in Halbleiterscheiben zu zerteilen. Bei relativ kurzen Einkristallen mit relativ großen Durchmessern im zylindrischen Abschnitt bedeutet diese Praxis den Verzicht auf einen beträchtlichen Teil der potentiell verwertbaren Kristallmasse.

Wird der an den Anfangskonus angrenzende Teil des zylindrischen Abschnitts dennoch zu Halbleiterscheiben zerteilt, so läßt sich auf den Scheiben ein ringförmiger Bereich (Stapelfehlerkranz) nachweisen, in dem oxidationsinduzierte Stapelfehler in hoher Dichte auftreten. Die Hersteller von elektronischen Bauelementen bevorzugen jedoch Halbleiterscheiben mit möglichst niedriger Stapelfehlerdichte. Halbleiterscheiben mit Stapelfehlerkranz gelten daher als minderwertig.

Nun ist bekannt, daß der Durchmesser des Stapelfehlerkranzes proportional zur Ziehgeschwindigkeit ist, mit der der Einkristall gezogen wurde, und zwar zu dem Zeitpunkt, als das Halbleitermaterial, das die später gewonnene Halbleiterscheibe umfaßt, kristallisierte. Bei einer bestimmten Ziehgeschwindigkeit verschwindet der Stapelfehlerkranz gleichsam, weil sein Durchmesser mit dem Durchmesser der späteren Halbleiterscheibe übereinstimmt. Es wird daher versucht, diese Ziehgeschwindigkeit beim Ziehen des Einkristalls schnell zu erreichen, um das Auftreten des Stapelfehlerkranzes auf den Anfangskonus und auf einen möglichst kurzen Teil des angrenzenden zylindrischen Abschnitts zu beschränken. Dies gelingt jedoch nur unzureichend. Darüber hinaus ist bekannt, daß die Durchschlagsfestigkeit von Oxidfilmen, die im Fachjargon als Gate-Oxid-Integrity (GOI) bezeichnet wird und ein wichtiges Kriterium bei der Beurteilung der Qualität von Halbleiterscheiben darstellt, von der Ziehgeschwindigkeit indirekt proportional abhängig ist.

Aus der FR-A-1.420.234 ist ein Verfahren und Vorrichtung zum Ziehen eines Silicium-Einkristalls aus einer Schnelze bekannt, wobei der Einkristall durch die Öffnung einer Abdeckung nach oben gezogen wird.

Die Aufgabe der vorliegenden Erfindung bestand daher darin, das Verfahren zu verbessen, damit Silicium-Einkristalle mit einem zylindrischen Abschnitt hergestellt werden können, der sich nahezu vollständig zu qualitativ hochwertigen Halbleiterscheiben ohne Stapelfehlerkranz zerteilen läßt.

Gelöst wird die Aufgabe durch ein Verfahren der genannten Gattung, das dadurch gekennzeichnet ist, daß die Oberfläche des konusförmigen Abschnitts am Anfang des Einkristalls mit einem vom Einkristall beabstandeten Abschirmteil von 20 bis 100 % abgedeckt wird. Weiter wird die Aufgabe gelöst durch eine Vorrichtung wie in Anspruch 4 beansprucht.

Das Abschirmteil behindert die freie Wärmeabstrahlung von der Oberfläche des Anfangskonus in die Umgebung. Wie die Erfinder festgestellt haben, bewirkt die reduzierte Wärmeabstrahlung, daß bereits bei niedrigeren Ziehgeschwindigkeiten als bisher üblich der Durchmesser des Stapelfehlerkranzes mit dem Durchmesser des wachsenden Einkristalls übereinstimmt. Gleichzeitig wird die Länge des an den Anfangskonus angrenzenden Teils des zylindrischen Abschnitts, der noch mit einem Stapelfehlerkranz behaftet ist, um mindestens 50 % verkürzt. Durch die reduzierte Ziehgeschwindigkeit ergibt sich auch eine Verbesserung bei den getesteten GOI-Werten. Der GOI ist bei vergleichbaren Halbleiterscheiben deutlich schlechter, wenn die Halbleiterscheiben aus dem an den Anfangskonus angrenzenden Teil des zylindrischen Abschnitts stammen und der Einkristall gezogen wurde, ohne daß der Anfangskonus erfindungsgemäß abgedeckt war. Dies ist auch dann der Fall, wenn diese Halbleiterscheiben keinen Stapelfehlerkranz aufweisen, weil der Einkristall bereits zum Zeitpunkt der Entstehung dieses Teils des zylindrischen Abschnitts mit einer ausreichend hohen Geschwindigkeit gezogen worden war.

Bei Ausübung der Erfindung wird beim Ziehen des Einkristalls die Oberfläche des Anfangskonus mit einem Abschirmteil thermisch abgeschirmt. Das Abschirmteil reduziert die Wärmeabstrahlung von der Oberfläche des Anfangskonus und ist dafür verantwortlich, daß der Temperaturabfall zwischen der Kristallisationsgrenze und dem bereits kristallisierten Teil des Anfangskonus, gering ist. Das Abschirmteil sollte jedoch nicht mit dem wachsenden Einkristall in Kontakt kommen, weil bei einer Berührung Versetzungen im Einkristall induziert werden könnten. Der Abstand zwischen dem Abschirmteil und der Oberfläche des Anfangskonus beträgt 5 bis 200 mm, vorzugsweise 10 bis 100 mm. Da sich der Abstand zwischen Anfangskonus und Schmelzenoberfläche während des Kristallzugs ändert, muß das Abschirmteil in Richtung der Längsachse des Einkristalls bewegbar sein. Es kann dann in die vorgesehene Position über der Oberfläche des Anfangskonus gebracht und im vorgesehenen Abstand zur Oberfläche des Anfangskonus gehalten werden. Die Positionierung des Abschirmteils geschieht vorzugsweise mit Beginn des Ziehens des Anfangskonus. Natürlich kann das Abschirmteil auch schon vor diesem Zeitpunkt oder kurze Zeit danach in die vorgesehene Position gebracht werden. Der Anfangskonus wird mit dem Abschirmteil mindestens solange abgedeckt, bis ein 20 bis 100 mm langer Teil des zylindrischen Abschnitts des Einkristalls gezogen worden ist. Das Abschirmteil sollte mindestens 20 bis 100 % der Oberfläche des Anfangskonus abdecken, wobei diese Angabe sich auf den vollständig gezogenenen Anfangskonus bezieht.

Um die abschirmende Wirkung zu verstärken, kann das Abschirmteil zusätzlich über des Rand des Einkristalls hinausragen. Das Abschirmteil ist aus einem Material zu fertigen, das unter den beim Ziehen des Einkristalls vorherrschenden Bedingungen stabil bleibt und von dem keine Kontaminationsgefahr für den wachsenden Einkristall ausgeht. Bevorzugt besteht das Abschirmteil aus Graphit, Silicium oder Quarz oder es ist mit einem dieser Stoffe beschichtet. Besonders bevorzugt ist ein Abschirmteil aus graphitummanteltem Graphitfilz.

In den Figuren sind bevorzugte Ausführungsformen des Abschirmteils dargestellt. Gleiche Bezugsziffern verweisen auf dieselben Merkmale. Es sind nur solche Merkmale dargestellt, die zur Erläuterung der Erfindung notwendig sind.
Figur 1 zeigt schematisch die Seitenansicht auf eine Vorrichtung zum Ziehen von Silicium-Einkristallen; in den
Figuren 2a und 2b ist die Draufsicht auf den Anfangskonus eines wachsenden Einkristalls dargestellt.

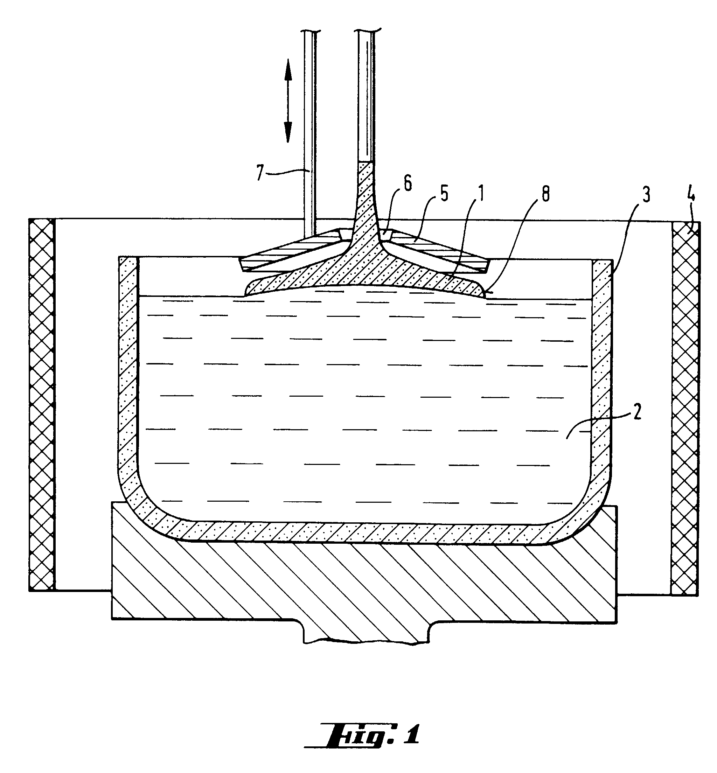

Gemäß Figur 1 ist das Ziehen des Anfangskonus 1 des Einkristalls aus der Schmelze 2 bereits vollzogen. Die Schmelze 2 füllt einen Tiegel 3 aus, der von einem Heizelement 4 umgeben ist. Die Oberfläche des Anfangskonus wird von einem darüber in bestimmtem Abstand angeordneten Abschirmteil 5 weitgehend abgedeckt. Das Abschirmteil besitzt eine zentrale Öffnung 6, durch die der Einkristall mit seinen "Dünnhals" ragt. Die Öffnung 6 verleiht dem Abschirmteil das Aussehen von einer Kreisscheibe oder von einem Konus mit abgetrennter Spitze. Die dem Anfangskonus gegenüberliegende Fläche des Abschirmteils kann, wie es in der Figur dargestellt ist, nahezu parallel zur Oberfläche des Anfangskonus liegen. Es ist jedoch ebenso möglich, daß die beiden Flächen in einem bestimmten Winkel zueinander liegen. Weiterhin ist das Abschirmteil so angeordnet, daß es senkrecht zur Oberfläche der Schmelze bewegt werden kann. In der gezeigten Ausführungsform ist das Abschirmteil für diesen Zweck mit einer axial verschiebbaren Stange 7 verbunden. Natürlich können aber auch andere, gleichwertige Lösungen verwendet werden, um die Bewegbarkeit des Abschirmteils zu erreichen.

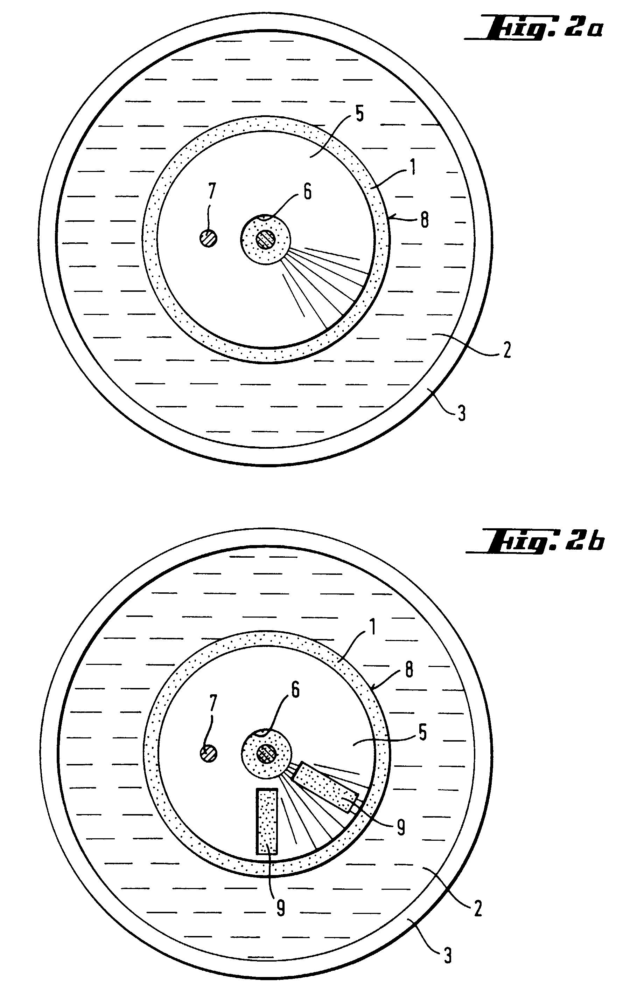

Den Figuren 2a und 2b kann entnommen werden, daß die Oberfläche des Anfangskonus nicht vollständig vom Abschirmteil überdeckt sein muß. In der Darstellung ragt ein Randbereich 8 des Anfangskonus über den Rand des Abschirmteils 5 heraus. Es ist jedoch auch möglich, den Durchmesser des Abschirmteils größer zu wählen, so daß aus der dargestellten Perspektive auch der Randbereich 8 vom Abschirmteil 5 abgedeckt erscheint. Das in der Figur 2b gezeigte Abschirmteil 5 weist zusätzlich zwei Sichtschlitze 9 in Form von Aussparungen auf. Solche Sichtschlitze sind vorgesehen, um beim Ziehen des Einkristalls den einsehbaren Teil der Kristallisationsgrenze beobachten und den aktuellen Durchmesser des Einkristalls kontrollieren zu können. Wenn zwei Sichtschlitze vorhanden sind, kann einer zur Beobachtung mittels einer Kamera und der zweite zur Beobachtung durch den Bediener der Ziehanlage genutzt werden. Ein weiterer Vorteil von Sichtschlitzen ist, daß das Abschirmteil bereits zu Beginn des Ziehens des Anfangskonus in die vorgesehene Position gebracht werden kann. Ohne Sichtschlitze kann es notwendig sein, daß das Abschirmteil erst nach und nach in Richtung auf den wachsenden Anfangskonus bewegt werden muß, weil zunächst ein bestimmter Mindestabstand über dem Anfangskonus eingehalten werden muß, um am Rand des Abschirmteils vorbei zur Kristallisationsgrenze blicken zu können.

Bei den dargestellten Abschirmteilen handelt es sich lediglich um bevorzugte Ausführungsformen. Es ist klar, daß der Anfangskonus mit gleicher Wirkung auch durch ein andersartig geformtes Abschirmteil abgedeckt werden kann, das auch aus zwei oder mehreren Einzelteilen bestehen kann.

## Patentansprüche

1. Verfahren zum Ziehen eines Silicium-Einkristalls aus einer Schmelze, umfassend das Ziehen je eines konusförmigen Abschnitts am Anfang und am Ende des Einkristalls und das Ziehen eines zylindrischen Abschnitts zwischen den konusförmigen Abschnitten, dadurch gekennzeichnet, daß die Oberfläche des konusförmigen Abschnitts am Anfang des Einkristalls mit einem vom Einkristall beabstandeten Abschirmteil von 20 bis 100 % abgedeckt wird.

2. Verfahren nach Anspruch 1, dadurch gekennzeichnet, daß die Oberfläche des konusförmigen Abschnitts am Anfang des Einkristalls mindestens solange abgedeckt wird, bis ein 20 bis 100 mm langer Teil des zylindrischen Abschnitts gezogen worden ist.

3. Verfahren nach Anspruch 1 oder Anspruch 2, dadurch gekennzeichnet, daß der Abstand zwischen dem Abschirmteil und der Oberfläche des konusförmigen Abschnitts am Anfang des Einkristalls 5 bis 200 mm beträgt.

4. Vorrichtung zum Ziehen eines Silicium-Einkristalls aus einer Schmelze, umfassend ein vom Einkristall beabstandetes Abschirmteil mit einer zentralen Öffnung für einen Dünnhals des Einkristalls, dadurch gekennzeichnet, daß das Abschirmteil derart angeordnet ist, daß die Oberfläche eines konusförmigen Abschnitts am Anfang des Einkristalls von 20 bis 100 % abgedeckt wird, und Mittel vorhanden sind, die die Bewegbarkeit des Abschirmteils in Richtung zur Schmelze und in entgegengesetzter Richtung ermöglichen.

5. Vorrichtung nach Anspruch 4, dadurch gekennzeichnet, daß das Abschirmteil aus einem Material besteht oder mit einem Material beschichtet ist, das aus der Gruppe von Stoffen gewählt ist, die Graphit, graphitummantelten Graphitfilz, Silicium und Quarz umfaßt.

6. Vorrichtung nach Anspruch 4 oder Anspruch 5, dadurch gekennzeichnet, daß das Abschirmteil derart angeordnet ist, daß sein Abstand zur Oberfläche des konusförmigen Abschnitts am Anfang des Einkristalls 5 bis 200 mm beträgt.

7. Vorrichtung nach einem der Ansprüche 4 bis 6, dadurch gekennzeichnet, daß das Abschirmteil mindestens eine Aussparung aufweist, durch die eine Beobachtung der Oberfläche des konusförmigen Abschnitts am Anfang des Einkristalls möglich ist.

8. Vorrichtung nach einem der Ansprüche 4 bis 7, dadurch gekennzeichnet, daß das Abschirmteil die Form von einer Kreisscheibe oder von einem Konus mit abgetrennter Spitze besitzt.

## Claims

1. Method for pulling a silicon monocrystal from a melt, comprising the pulling of a conical portion at the beginning and at the end of the monocrystal and the pulling of a cylindrical portion between the conical portions, characterized in that the surface of the conical portion at the beginning of the monocrystal is shielded from 20 to 100% with a shielding part which is spaced apart from the monocrystal.

2. Method according to Claim 1, characterized in that the surface of the conical portion at the beginning of the monocrystal is shielded at least until a part of the cylindrical portion having a length of from 20 to 100 mm has been pulled.

3. Method according to Claim 1 or Claim 2, characterized in that the distance between the shielding part and the surface of the conical portion at the beginning of the monocrystal is 5 to 200 mm.

4. Device for pulling a silicon monocrystal from a melt, comprising a shielding part which is spaced apart from the monocrystal and has a central opening for a thin neck of the monocrystal, characterized in that the shielding part is arranged in such a way that the surface of a conical portion at the beginning of the monocrystal is shielded from 20 to 100%, and means are present which permit the mobility of the shielding part in the direction towards the melt and in the opposite direction.

5. Device according to Claim 4, characterized in that the shielding part is composed of a material, or is coated with a material, which is chosen from the group of substances which comprises graphite, graphite-sheathed graphite felt, silicon and quartz.

6. Device according to Claim 4 or Claim 5, characterized in that the shielding part is arranged in such a way that its distance to the surface of the conical portion at the beginning of the monocrystal is 5 to 200 mm.

7. Device according to any of Claims 4 to 6, characterized in that the shielding part has at least one cutout through which observation of the surface of the conical portion at the beginning of the monocrystal is possible.

8. Device according to any of Claims 4 to 7, characterized in that the shielding part has the shape of a circular disc or of a cone having a removed tip.

## Revendications

1. Procédé pour le tirage d'un monocristal de silicium à partir d'un bain fondu, comprenant le tirage de chaque fois un segment conique au début et à la fin du monocristal et le tirage d'un segment cylindrique entre les segments coniques, caractérisé en ce que la surface du segment conique au début du monocristal est recouverte de 20 à 100% par un élément de protection espacé du monocristal.

2. Procédé suivant la revendication 1, caractérisé en ce que la surface du segment conique au début du monocristal est recouverte au moins jusqu'à ce qu'une partie du segment cylindrique d'une longueur de 20 à 100 mm soit tirée.

3. Procédé suivant la revendication 1 ou 2, caractérisé en ce que la distance entre l'élément de protection et la surface du segment conique au début du monocristal atteint 5 à 200 mm.

4. Dispositif pour le tirage d'un monocristal de silicium à partir d'un bain fondu, comprenant un élément de protection espacé du monocristal et pourvu d'une ouverture centrale pour un col de petite section du monocristal, caractérisé en ce que l'élément de protection est agencé de sorte que la surface d'un segment conique au début du monocristal est recouverte de 20 à 100% et en ce que des moyens sont prévus pour permettre à l'élément de protection de se déplacer en direction du bain fondu et en sens inverse.

5. Dispositif suivant la revendication 4, caractérisé en ce que l'élément de protection est fait d'un matériau ou est recouvert d'un matériau choisi dans le groupe des substances qui comprend le graphite, le feutre de graphite enrobé de graphite, le silicium et le quartz.

6. Dispositif suivant la revendication 4 ou 5, caractérisé en ce que l'élément de protection est agencé de sorte que la distance le séparant de la surface du segment conique au début du monocristal atteint 5 à 200 mm.

7. Dispositif suivant l'une quelconque des revendications 4 à 6, caractérisé en ce que l'élément de protection comporte au moins un évidement au travers duquel il est possible d'observer la surface du segment conique au début du monocristal.

8. Dispositif suivant l'une quelconque des revendications 4 à 7, caractérisé en ce que l'élément de protection a la forme d'un disque ou d'un cône tronqué.
